# EUROPEAN PATENT APPLICATION

(11) **EP 4 838 304 A1**
(43) Date of publication of application: **11.11.2026**
(21) Application number: 25175175.6
(22) Date of filing: 08.05.2025
(51) Int. Cl.: G03F 9/00, H01L 23/544

(54) **ALIGNMENT SENSOR**

(71) Applicant: ASML Netherlands B.V., 5500 AH Veldhoven (NL)
(72) Inventor: HESP, Niels, Caspar, Herman, 5500 AH Veldhoven (NL); BEUKMAN, Arjan, Johannes, Anton, 5500 AH Veldhoven (NL)
(74) Representative: ASML Netherlands B.V.

(57) **Abstract**

An alignment sensor configured to measure alignment of a sample, the alignment sensor comprising: an imager configured to image a region of interest of the sample; and a controller configured to: coarsely measure the alignment based on a distinguishing feature within the image; and finely measure the alignment based on a portion of the image with lower aberration than the distinguishing feature.

## Description

### TECHNICAL FIELD

The present disclosure relates generally to an alignment sensor, a bonding tool, a lithographic apparatus, a metrology tool, an alignment mark, a substrate, a method for measuring alignment of a sample, a computer program, a non-transient computer program carrier, a metrology apparatus and an inspection apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

In manufacturing processes of ICs, multiple substrates (which may be finished or unfinished ICs, e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple substrates. These specific portions may be aligned in three-dimensional space to ensure functional connectivity.

Alignment of the substrates, which may each have multiple fabrication layers, different critical dimensions, different nodes, packaging, etc., may require different techniques than those used for lithography during fabrication. As the physical sizes of IC components continue to shrink, and their structures continue to become more complex, accuracy in integration is becoming more important.

In the context of semiconductor manufacture, improvements in substrate placement and alignment lead to improvements in the overall IC manufacturing process.

### SUMMARY

According to an embodiment, the present disclosure provides an alignment sensor configured to measure alignment of a sample, the alignment sensor comprising:
an imager configured to obtain image data of a region of interest of the sample, the image data corresponding to a single image capturing process of the imager; and
a controller configured to:
   coarsely measure the alignment of the sample within a field of view of the imager based on a distinctive portion of the image data, the distinctive portion corresponding to a distinctive feature of the sample within the region of interest; and
   finely measure the alignment based the image data corresponding to a high image quality region within the field of view at which the imager is configured to obtain image data with higher image quality than the distinctive portion.

According to an embodiment, the present disclosure provides an alignment mark to be imaged so as to measure alignment of a sample, the alignment mark comprising:
a periodic pattern of product features; and
a break in the periodic pattern for facilitating coarse measurement of the alignment.

According to an embodiment, the present disclosure provides a method for calculating alignment of a sample, the method comprising:
coarsely measuring the alignment of the sample within a field of view of an imager based on a distinctive portion of image data of a region of interest of the sample obtained in a single image capturing process of the imager, the distinctive portion corresponding to a distinctive feature of the sample within the region of interest; and
finely measuring the alignment based on the image data corresponding to a high image quality region within the field of view at which the imager is configured to obtain image data with higher image quality than the distinctive portion.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts. The accompanying schematic drawings include the following.
Figures 1A-1D are schematic diagrams illustrating an exemplary die bonding method.
Figure 2 is a schematic diagram illustrating a bonding tool.
Figure 3 schematically depicts an alignment sensor.
Figure 4 schematically depicts a field of view of the alignment sensor.
Figure 5 is a graph showing the relationship between distance from the optical axis and magnitude of aberrations for different optical systems.
Figure 6 schematically depicts a field of view of the alignment sensor.
Figure 7 schematically depicts a field of view of the alignment sensor.
Figure 8 schematically depicts illumination within the field of view of the alignment sensor.
Figure 9 depicts a schematic overview of a lithographic apparatus.
Figure 10 is a schematic block diagram of an imager of an alignment sensor.
Figure 11 depicts a lithographic system comprising a lithographic apparatus and a radiation source.

### DETAILED DESCRIPTION

Embodiments of the present disclosure are described in detail with reference to the drawings, which are provided as illustrative examples of the disclosure so as to enable those skilled in the art to practice the disclosure. Notably, the Figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure.

Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "wafer" or "die" in this text should be each considered as interchangeable with the more general term "substrate". The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions.

A patterning apparatus (for example, a lithographic apparatus) can comprise, or can form, one or more patterns, which may correspond to one or more die. The patterns can be generated utilizing CAD (computer-aided design) programs, based on a pattern or design layout, this process often being referred to as EDA (electronic design automation).

As used throughout this application "or", unless indicated otherwise, takes a non-exclusive meaning, e.g., encompassing both "and" and "or".

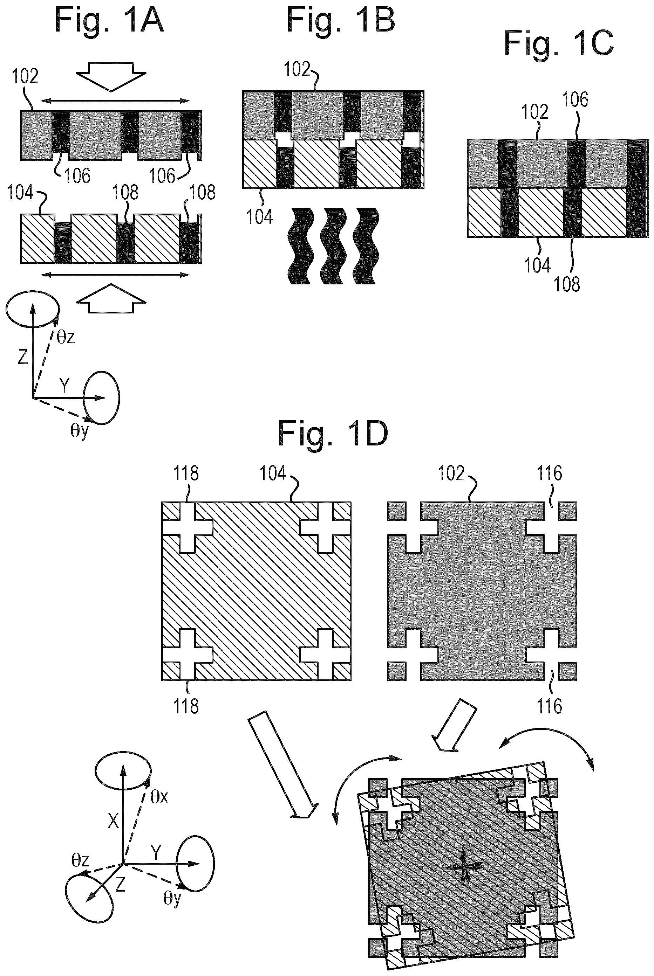

Reference is now made to Figures 1A-1D, which are schematic diagrams illustrating an exemplary die bonding method consistent with embodiments of the present disclosure. The die bonding method comprises bonding one die to another die. As will be appreciated, the bonding technique may be applied to bond any substrate (e.g. a whole wafer, a diced wafer, a partially-diced wafer, a chip, a die, etc.) to any other substrate (e.g. a whole wafer, a diced wafer, a partially-diced wafer, a chip, a die, etc.). For example, the bonding technique may be used to bond a die to another die, where the other die is a part of a wafer.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative and that elements described as corresponding to a "donor" can instead correspond to a "target" and vice versa.

The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target die.

The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas or dielectric areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

Figures 1A-1C depict a cross-sectional view of portions of the exemplary die bonding method. As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. As further shown in Figure 1A, the donor die 102 and the target die 104 may be brought together along the z-axis, while the position of the donor die 102 and/or the target die 104 may be adjusted in the x-y plane (e.g., perpendicular to the z-axis of approach). The alignment may be complicated by the multiple layers of the donor die 102 or the multiple layers of the target die 104, which may be optically opaque.

Upon bringing the donor die 102 into contact with the target die 104, an initial bond may be formed between the donor die 102 and the target die 104. The initial bond may be between dielectric areas of the donor die 102 and dielectric areas of the target die 104. The initial bond may comprise intermolecular forces, such as Van der Waal's forces and the like.

As shown in Figure 1B, the donor die 102 and the target die 104 may be annealed after contact. Annealing may be or include heat annealing, electrical annealing, electrostatic processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction. In direct die-to-die alignment, the donor die 102 and the target die 104 are aligned directly with one another.

Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non-zero linewidth portion of the wafer volume when separating die.

The electrically active areas 106 of the donor die 102 or the electrically active areas 108 of the target die 104 (not shown in Figure 1D) or other surface features may function as reference marks for alignment (e.g., alignment marks) of the donor die 102 and the target die 104.

The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the x-axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

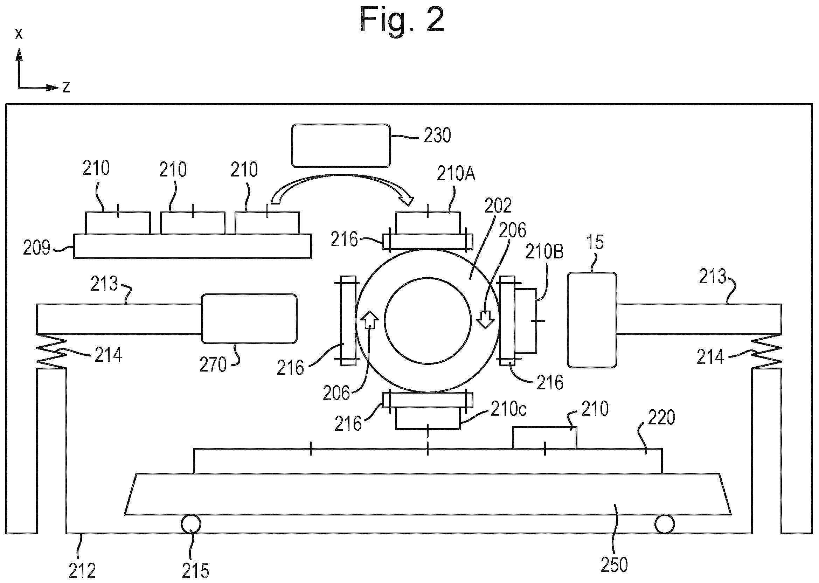

Figure 2 is a schematic diagram illustrating a bonding tool for the placement of donor substrates 210 onto an acceptor substrate 220 by a moveable stage 202. Figure 2 is described with reference to "donor" substrates 210 (e.g. donor substrates 210A-210C) and "acceptor" substrates 220, which are relative descriptors - a donor substrate may instead be an acceptor substrate, and vice-versa. The bonding tool depicted in Figure 2 may be configured to place any donor substrate (e.g. a whole wafer, a diced wafer, a partially-diced wafer, a chip, a die, etc.) onto any target substrate (e.g. a whole wafer, a diced wafer, a partially-diced wafer, a chip, a die, etc.). For example (and as depicted in Figure 2), the bonding tool may be configured to place a donor die 210 onto an acceptor wafer 220.

The acceptor substrate 220 may comprise one or more target portions. For example, the acceptor substrate 220 may comprise one or more target dies formed therein (prior to being diced/separated). The method/apparatus depicted in Figure 2 may be to place a donor die 210 onto a target die of the acceptor wafer 220. In the case that the acceptor wafer 220 comprises a plurality of target dies, the method may be repeated such that each donor die 210 is placed onto one of the plurality of target dies on the acceptor wafer 220.

The placing of a donor substrate 210 onto an acceptor substrate 220 may be a part of a bonding process comprising bonding the donor substrate 210 and the acceptor substrate 220 together. The bonding between the donor substrate 210 and the acceptor substrate 220 may be the same, or similar to, the bonding described with reference to Figure 1.

The stage 202 may be substantially circular in the x-z plane, with a longitudinal axis along the y-direction (e.g. the stage 202 may be substantially cylindrical in three dimensions). The stage 202 may instead have a different cross-sectional shape, such as square, hexagonal, etc. The stage 202 may have a symmetrical (e.g., as shown) cross-section with one or more axis of symmetry, or asymmetrical cross-sectional area (for example, an irregular polygon).

The stage 202 may comprise receiver portions 216. The receiver portions 216 each may be, or may comprise, a recess. The receiver portions 216 may each be configured to receive and/or accept and/or support and/or hold and/or clamp a donor substrate 210. The receiver portions 216 may each be configured to clamp a donor substrate 210 thereto using a vacuum clamping means and/or an electrostatic clamping means.

The placement of the receiver portions 216 may be symmetrical or asymmetrical around the cross-sectional area of the stage 202. The stage 202 may have a substantially symmetrical cross-section but have asymmetric placement of receiver portions 216. For example, the stage 202 may have a cross-section that is a regular hexagon but have receiver portions 216 placed asymmetrically along longitudinal faces.

The stage 202 may be a moveable stage, e.g. a rotatable stage. The stage 202 may be controllably moved (e.g. rotated) in a direction 206 about the longitudinal axis. The direction 206 is provided as an example. The stage 202 may instead be rotated in an opposite direction or any appropriate direction, translated along the x, y, or z direction or any combination thereof. The stage 202 may be operated in both rotational and translational modes, including sequentially or at the same time. For example, the stage 202 may move in the negative x-direction towards a support structure 250 while also rotating about the longitudinal axis. The stage 202 may move continuously or intermittently. For example, the stage 202 may rotate in the direction 206 and stop at four (or fewer or more) positions corresponding to operations in the placement of the donor substrate 210.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the stage 202 is substantially zero), but the positions may instead correspond to continuous (or quasi-continuous movement) or operations may occur while the stage 202 is moving in one or more directions (e.g., rotationally, translationally, etc.).

A first position, such as corresponding to the position depicted for the donor substrate 210A, may correspond to placement of a donor substrate 210A in a receiver portion 216 of the stage 202. The donor substrate 210A may be placed on the receiver portion 216 by a pick and place element 230. The pick and place element 230 may place the donor substrate 210A on the stage 202 on the receiver portion 216 based on alignment information, based on positional information of the stage 202, etc. The pick and place element 230 may place the donor substrate 210A on the support structure at a given position relative to the receiver portion 216. For example, the pick and place element 230 may center the donor substrate 210A relative to the receiver portion 216.

The second position, such as corresponding to the position depicted for the donor substrate 210B, may correspond to measurement of the position of the donor substrate 210B relative to the receiver portion 216 of the stage 202. The position (e.g., location) of the donor substrate 210B may be measured by an alignment sensor 15. The alignment sensor 15 may measure an actual position of the donor substrate 210B, in relative (such as relative to the receiver portion 216) or absolute terms (such as in distances from an origin point on the stage 202, on the alignment sensor 15, etc.).

The alignment sensor 15 may comprise a camera, e.g., a two-dimensional camera, two or more one-dimensional cameras, an optical camera, etc., or another measurement device. The alignment sensor 15 may be made up of multiple alignment sensors, such as an in-plane measurement device which may measure locations in the y-z plane (relative to the reference axes) and an out-of-plane measurement device which may measure locations or distances in the x direction (relative to the reference axes). The alignment sensor 15 may include one or more confocal microscopes, which may measure depth (or other distance). The alignment sensor 15 may measure position, relative or absolute position, using overlay diffraction or other diffraction-based methods. The alignment sensor 15 may operate in a scanning mode or from a fixed position relative to the stage 202.

Once the position of the donor substrate 210B is measured, the stage 202 may move (e.g., rotate in the direction 206), so that the donor substrate 210B occupies the position of the donor substrate 210C, which may be a third position of the stage 202. The third position of the support structure will now be described with reference to the donor substrate 210C.

The third position, such as corresponding to the position depicted for the donor substrate 210C, may correspond to placement of the donor substrate 210C on the acceptor substrate 220. The acceptor substrate 220 may comprise a target portion (e.g. a target die, as described above). The bonding tool may be configured to place the donor substrate 210C at the target portion of the acceptor substrate 220 by bringing the donor substrate 210C into contact with the target portion of the acceptor substrate 220. As the donor substrate 210C is brought into contact with the target portion of the acceptor substrate 220, initial bonding forces (e.g. Van der Waal's forces and the like) may be formed between the donor substrate 210C and the acceptor substrate 220.

The acceptor substrate 220 may be supported by the support structure 250. The donor substrate 210C may be brought into contact with the acceptor portion by motion of the stage 202 towards the support structure 250, motion of the support structure 250 towards the stage 202, or a combination thereof. Motion of the stage 202 towards the support structure 250 may comprise movement in the z-direction. Motion of the support structure 250 towards the stage may comprise movement in the z-direction.

Once the donor substrate 210C is placed on the acceptor substrate 220, the stage 202 and the support structure 250 may operate (individually or in concert) to place at least one additional donor substrates on the acceptor substrate 220. For example, the stage 202 and the support structure 250 may move relative to one another in the x- or y-direction so that another part of the acceptor substrate 220 is proximate to the stage 202 (e.g. so that another target portion of the acceptor substrate 220 is aligned with the stage 202). The relative motion of the stage 202 and the support structure 250 may be caused by movement of the support structure 250 (e.g. by the positioning system for the support structure 250).

After placing the donor substrate 210C onto the acceptor substrate 220, the stage 202 may rotate to align the next donor substrate on the stage (i.e. the donor substrate 210B) with the acceptor substrate 210. Generally, the stage 202 may be rotatable to align different donor substrate 210 (and/or different receiver portions 216 of the plurality of receiver portions 216) with the acceptor substrate 220.

A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by clamps, suction, vacuum, and other forces.

The stage 202 may comprise an actuator (not shown). The actuator may be configured to cause the stage 202 to accept the donor substrates 210 from the pick & place element 230 and subsequently transport the donor substrates 210 to alignment sensor 15 and finally place the donor substrates 210 on the acceptor substrate 220. The actuator may be configured to rotate the stage 202 in the manner described above.

The support structure 250 may be configured to move the acceptor substrate 220 with high accuracy. The bonding tool may comprise a base frame 212. As shown in Figure 2, the support structure 250 that supports the acceptor substrate 220 may be coupled to the base frame 212 by at least one bearing 215. The support structure 250 may comprise a plurality of stages that may be stacked relative to each other via a plurality of bearings.

For example, the support structure 250 may comprise a long stroke module for relatively coarse positioning of the acceptor substrate 220 over a longer distance, and a short stroke module for higher accuracy positioning of the acceptor substrate 220 over a shorter distance. The short stroke module may be stacked on the long stroke module. The short stroke module and the long stroke module may each be part of a positioning system configured to position the support structure 250 (and therefore to position the acceptor substrate 220 supported on the support structure 250) in the horizontal plane, i.e. in the x- and y-directions. The short stroke module and the long stroke module may each comprise one or more actuators configured to move the support structure 250 relative to the base frame 212. Thus, in general, the positioning system may comprise one or more actuators configured to move the support structure 250.

The positioning system may comprise one or more sensors configured to determine the position of the support structure. The one or more sensors may be interferometric sensors, as described in US6020964, the entirety of which is hereby incorporated by reference.

As shown in Figure 2, the bonding tool may comprise a metrology frame 213.

The metrology frame 213 may be referred to as an isolated frame. The metrology frame 213 may be isolated relative to the base frame 212. The bonding tool may comprise an isolator 214. The isolator 214 may be configured to substantially isolate the metrology frame 213 from the base frame 212. By isolating the metrology frame 213 from the base frame 212, vibrations of the base frame 212 may have less of an effect on the metrology frame 213.

As shown in Figure 2, in an embodiment the bonding tool comprises an acceptor exchange element 270. The acceptor exchange element 270 may be secured to the metrology frame 213. The acceptor exchange element 270 is configured to exchange a receiver portion 216 of the stage 202 for a replacement receiver portion. Alternatively, the acceptor exchange element 270 may be omitted.

A controller may be configured to control the stage 202 and the support structure 250 so as to accurately place a donor substrate 210 onto a target portion of the acceptor substrate 220.

Alignment between the donor substrate 210 and the acceptor substrate 220 in the horizontal (x and y) directions is important. This is because, as described above, the donor substrate 210 and the acceptor substrate 220 each have electrically-active areas which must come into contact with each other for the combination of the donor substrate 210 and the acceptor substrate 220 to function as intended. As above, a direct substrate-to-substrate alignment method may be performed. Additionally or alternatively, an alignment method may be performed whereby the position of the donor substrate 210 is determined relative to a reference, and the position of the acceptor substrate 220 is determined relative to a reference, and the substrates 210, 220 are aligned using the two determined positions. Such an alignment method is described below.

To accurately align the donor substrate 210 and the acceptor substrate 220, the position of the donor substrate 210 relative to the acceptor substrate 220 may be determined. The determination of the position of the donor substrate 210 relative to the acceptor substrate 220 may be direct, indirect, explicit or implicit. For example, the actual position of the donor substrate 210 relative to the acceptor substrate 220 itself may not be explicitly determined, but another parameter which is indicative of the position of the donor substrate 210 relative to the acceptor substrate 220 may be determined (and thus the position of the donor substrate 210 relative to the acceptor substrate 220 is determined indirectly/implicitly). The determination of the position of the donor substrate 210 relative to the acceptor substrate 220 may be may be done with use of alignment marks (e.g. like the alignment marks 118, 116 depicted in Figure 1) on the donor substrate 210 and the acceptor substrate 220.

Additionally or alternatively, the position of the donor substrate 210 relative to the acceptor substrate 220 may be determined based on determining the position of the stage 202 (e.g. the position of the receiver portion 216 in the third position) relative to the support structure 250. This may be possible because the position of the acceptor substrate 220 relative to the support structure 250 is accurately known and/or the position of the donor substrate 210 relative to the stage 202 (e.g. relative to the receiver portion 216) is accurately known. The position of the receiver portion 216 in the third portion relative to the stage 202 in general may be known and fixed (e.g. because the receiver portion 216 is fixedly coupled to a main body of the stage 202). Thus, knowledge of the position of the stage 202 relative to the support structure 250 may be equivalent to knowledge of the position of the receiver portion 216 in the third position relative to the support structure, and vice-versa.

The position of the acceptor substrate 220 relative to the support structure 250 may be known through a metrology process performed by a sensor, e.g. an alignment sensor. The position of the donor substrate 210 relative to the stage 202 (e.g. relative to the receiver portion 216) may be accurately known through measurements performed by the alignment sensor 15, as described above.

The alignment sensor used to obtain the position of the acceptor substrate 220 relative to the support structure 250 may be an interferometric sensor. The alignment sensor may be configured to determine a position of an alignment mark (e.g. a diffraction grating) on the acceptor substrate 220 relative to a reference mark (e.g. a diffraction grating) on the support structure 250. An example of an alignment sensor is described in EP1 372 040B1, the entirety of which is hereby incorporated by reference.

The alignment sensor may be disposed in a measurement station of the bonding tool (not shown). Although not shown in Figure 2, in an embodiment the measurement station may be separate and/or distinct from the bonding station of the bonding tool.

The bonding tool may comprise two support structures 250, each configured to support an acceptor substrate 220. The support structures 250 may be independently moveable. The support structures 250 may each be provided with a positioning system, such as the positioning system described above. Alternatively, the bonding tool may comprise a single positioning system which is configured to move the two support structures 250 independently. The bonding tool may be configured such that one support structure 250 can be positioned in the measurement station and the other support structure 250 can be positioned in the bonding station, simultaneously. Thus, preparatory measurement processes may be performed on one acceptor substrate 220 (in the measurement station) while bonding processes are performed on another acceptor substrate 220 (in the bonding station).

The position of the stage 202 (e.g. the position of the receiver portion 216 in the third position) relative to the support structure 250 may be determined by measuring the position of the stage 202 using one measurement system, and measuring the position of the support structure 250 using another, independent measurement system (e.g. the positioning system described above). The positions of the stage 202 and the support structure 250 may be measured in different coordinate systems, and/or with respect to different references.

For the bonding tool to be able to accurately place a donor substrate 210 at a target portion of the acceptor substrate 220, the relative position of the support structure 250 and the stage 220 may need to be accurately determined based on the measured position of the stage 202 and/or the measured position of the support structure 250 (specifically, in the x- and y-directions). In some embodiments, the position of the stage 202 in the x- and y-directions may be fixed, such that the determination of the position of the stage 202 relative to the support structure 250 in the x- and y-directions is based on the measurement of the position of the support structure 250 by the positioning system. Even where the position of the stage 202 in the x- and y-directions is fixed, the stage 202 may be able to rotate to align different receiver portions 216 with the acceptor substrate 220.

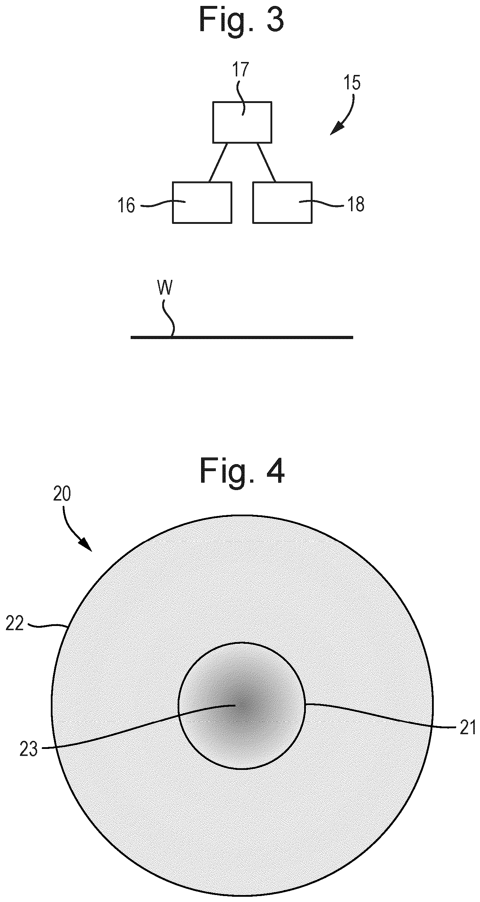

Figure 3 schematically depicts an alignment sensor. The alignment sensor 15 may be comprised in a bonding tool, such as shown in Figure 2, for example. In an embodiment the alignment sensor 15 is configured to measure alignment of a sample. For example, the sample may be a structure on a substrate. The substrate may be a substrate to be bonded. Both substrates that are bonded together may be substrates to be bonded. The alignment sensor 15 may be used to measure the alignment of one or both substrates to be bonded. The substrate may be a donor substrate 210 or an acceptor substrate 220, for example. In an embodiment the substrate is a donor die 102 or a target die 104, for example.

As shown in Figure 3, in an embodiment the alignment sensor 15 comprises an imager 16. The imager 16 is configured to obtain image data of a region of interest of the sample. The region of interest of the sample may correspond to part of the sample that is imaged by the imager 16. The imager 16 is referred to as an imager because it obtains image data. The image data is referred to as image data because the image data can be used to form an image of the region of interest of the sample. However, it is not essential for an image to be actually generated based on the image data. For example, the image data may be stored, processed, and/or transferred as image data without any image being formed or displayed based on the image data.

In an embodiment the imager comprises a camera. In an embodiment the imager 16 comprises a microscope. In an embodiment the microscope is a dark field microscope. By using a dark field microscope, the contrast across the region of interest of the sample may be clearer in the image data obtained by the imager 16. Alternatively, a bright field microscope may be used. In an embodiment the imager 16 comprises an objective lens. The objective lens may be configured to collect radiation from the sample to be detected by the imager 16.

In an embodiment the image data corresponds to a single image capturing process of the imager 16. For example, the image data may be obtained while the imager 16 remains stationary with respect to the sample (e.g. the substrate W as shown in Figure 3). This is different from a scenario in which the imager 16 obtains some image data and is subsequently used to collect further image data from the substrate W after some relative movement between the substrate W and the imager 16. The image data may comprise image data obtained at a plurality of different settings of the imager 16. For example, in an embodiment the imager 16 is configured to obtain a plurality of subsets of image data corresponding to different frequencies of radiation. In an embodiment the imager 16 is configured to obtain a plurality of subsets of image data corresponding to different polarisations of radiation. In an embodiment the imager 16 is configured to obtain the subsets of the image data in series. In an embodiment the imager 16 is configured to obtain the subsets of the image data in parallel.

As shown in Figure 3, in an embodiment the alignment sensor 15 comprises an illuminator 18. The illuminator 18 is configured to illuminate the region of interest, for example of the substrate W. In an embodiment the illuminator 18 is configured to emit radiation towards the substrate W. The signal radiation measured by the imager 16 may result from the radiation provided by the illuminator 18 on the substrate W.

As shown in Figure 3, in an embodiment the alignment sensor 15 comprises a controller 17. The controller 17 is configured to control the imager 16. In an embodiment the controller 17 is configured to control the illuminator 18. For example, the controller 17 may be configured to control the illuminator 18 so as to control the frequency of radiation with which the illuminator 18 illuminates the substrate W. In an embodiment the controller 17 is configured to control the illuminator 18 so as to control the polarisation of radiation with which the illuminator 18 illuminates the substrate W.

In an embodiment the controller 17 is configured to control the imager 16 to obtain the image data of the region of interest of the substrate W. For example, the controller 17 may be configured to control an image capturing process of the imager 16. In an embodiment the controller 17 is configured to control the imager 16 to obtain the image data while the imager 16 is substantially stationary relative to the substrate W.

Figure 4 schematically depicts a field of view 20 of the imager 16. The field of view 20 of the imager 16 may be referred to as the field of view 20 of the alignment sensor 15. Possible functions of the controller 17 are described with reference to the field of view 20 shown in Figure 4.

As shown in Figure 4, in an embodiment the fields of view 20 of the imager 16 comprises different zones. For example, the field of view 20 may comprise a high image quality region 21. In the arrangement shown in Figure 4, the high image quality region 21 is located in the centre of the field of view 20 of the imager 16. It is not essential for the high image quality region 21 to be located near the centre of the field of view 20. For example, in an alternative arrangement of the imager 16, the high image quality region 21 may be located offset from the centre of the field of view 20, or may be near the periphery of the field of view 20 of the imager 16, for example.

As shown in Figure 4, in an embodiment the field of view 20 comprises a low image quality region 22. As shown in Figure 4, in an embodiment the low image quality region 22 is located near the periphery of the field of view 20. The low image quality region 22 may be located radially outward of the high image quality region 21. The radial position is measured relative to the centre 23 of the field of view 20. As shown in Figure 4, in an embodiment the low image quality region 22 surrounds the high image quality region 21.

In an embodiment the level of image quality within the field of view 20 varies according to a function (i.e. a mathematical function). The image quality level may vary smoothly across the field of view 20. For example, the operation level may depend on the distance from the optical axis (which may correspond to the centre 23 of the field of view 20). There may not be a sudden step change between the image quality level within the high image quality region 21 and the image quality level within the low image quality region 22. Instead, the image quality level may gradually decrease as the distance from the centre 23 of the field of view 20 increases.

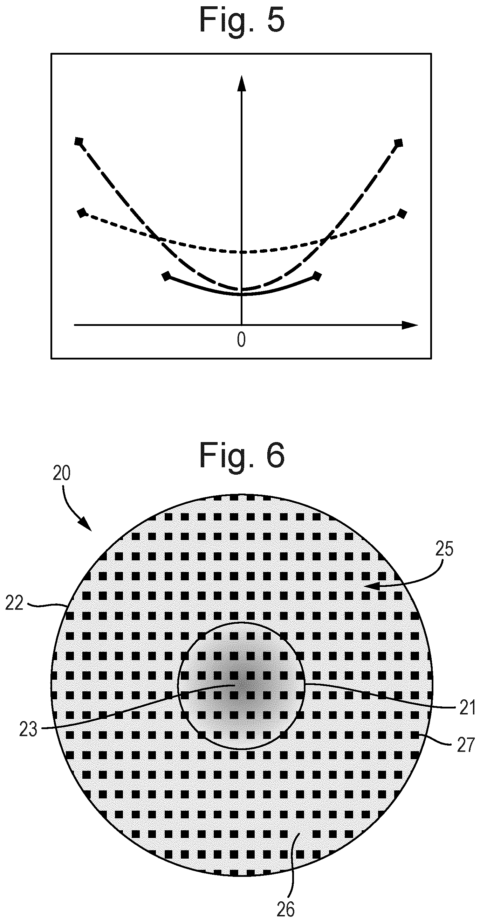

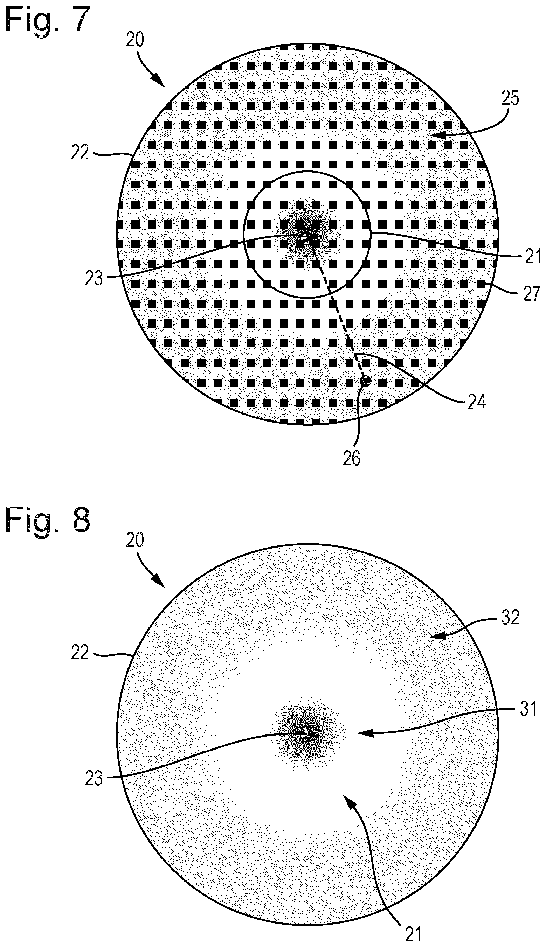

In an embodiment the controller 17 is configured to coarsely measure the alignment of the sample within the field of view 20 of the imager 16 based on a distinctive portion of the image data. For example, the distinctive portion of the image data may correspond to a distinctive feature 26 (shown and described in more detail with reference to Figure 6 and Figure 7, for example) of the sample. The distinctive feature 26 is within the region of interest. The distinctive feature 26 is a feature of the sample measured by the alignment sensor 15. The coarse alignment may be performed by making use of the full field of view 20. For example, the coarse alignment may be performed based on the distinctive portion of the image data, where that distinctive portion may correspond to any location within the field of view 20. For example, it is not necessary for the distinctive portion of the image data to correspond to the high image quality region 21. In an embodiment the distinctive portion of the image data corresponds to a location within the low image quality region 22 of the field of view 20. When the distinctive portion of the image data is located within the low image quality region 22, there may be relatively large aberrations and/or distortions, for example. However, it is not necessary to correct for the larger aberrations and/or distortions. Instead, the coarse alignment is for establishing the alignment of the sample within the field of view 20 to a coarse level of accuracy. A coarse level of accuracy may mean that the alignment of the sample is measured within the field of view 20 to an accuracy of better than 10 µm, optionally better than 5 µm, optionally better than 2 µm, and optionally better than 1 µm.

In an embodiment the controller 17 is configured to finely measure the alignment of the sample within the field of view 20 of the imager 16 based on image data corresponding to the high image quality region 21 within the field of view 20. The high image quality region 21 is a region at which the imager 16 is configured to obtain image data with higher image quality than the distinctive portion. That is, the high image quality region 21 is associated with higher image quality compared to where the distinctive feature 26 is located within the field of view 20.

For example, there may be features of the sample that allow measurement of position with fine alignment uncertainty. Within the high image quality region 21 (for example near the centre of the field of view 20) the imager 16 may be capable of determining the position of the sample with low or minimal error.

In an embodiment the controller 17 is configured to perform coarse alignment and fine alignment on the same image (or same set of image data that can be used to form a single image of the region of interest of the sample). Performing both the coarse alignment and the fine alignment on the same image is different from performing coarse alignment initially and subsequently moving the sample relative to the imager 16 so as to subsequently perform fine alignment. The same imager 16 obtains the same image data for both the coarse alignment and the fine alignment.

An embodiment of the invention is expected to decrease the time required to measure alignment of a sample. An embodiment of the invention is expected to increase throughput of alignment measurements. It is not necessary to perform a separate image capturing process for coarse alignment as well as for fine alignment, with relative movement of the sample to the alignment sensor 15. By capturing only one set of image data and using the same image for coarse alignment and fine alignment, less time is required to form the alignment measurement.

By performing the fine alignment based on image data within the high image quality region 21 of the field of view 20, it is not necessary to perform significant calibrations (i.e. corrections) so as to correct for low image quality (e.g. large aberrations). The aberration level within the high image quality region 21 is sufficiently low that the need for calibrations may be reduced or avoided altogether. An embodiment of the invention is expected to reduce processing power required to perform the alignment measurement. An embodiment of the invention is expected to reduce the time required for data processing in an alignment measurement.

The high image quality region 21 differs from the low image quality region 22 in one or more properties associated with image quality. For example, the property may be aberration level. In an embodiment the high image quality region 21 is a low aberration region and the low image quality region 22 is a high aberration region. The low aberration region has lower aberrations that the high aberration region.

Figure 5 is a schematic graph showing the relationship between distance from optical axis and magnitude of aberrations for a variety of different lenses. Figure 5 is only exemplary. In Figure 5, the X axis corresponds to the distance from the optical axis of a lens. The Y axis corresponds to the level of aberrations. As shown in Figure 5, typically a lens may have a lowest aberration towards the centre of the field of view, i.e. nearer to the optical axis. In general, the level of aberrations increases with distance from the optical axis. The aberration may comprise distortion, for example a phase offset that radiation incorporates when travelling through a lens. The aberration may comprise non-telecentricity, i.e. a measure of the extent to which radiation incorporates errors as a result of being non-parallel to the optical axis. In general, the distortion may increase with increasing distance from the optical axis. In general, the non-telecentricity may increase with increasing distance from the optical axis.

Figure 5 shows plot lines corresponding to two different types of lenses that have a large field of view (i.e. extending further in both directions in the X axis) and a third plot line corresponding to another lens that has a smaller field of view (not extending so far along the X axis). Among the two lenses with a large field of view, one has lower aberrations at the centre of the field of view, but higher aberrations towards the edge of the field of view. In general, there is a trade off between the aberration level near the centre of the field of view and the aberration level near the edge of the field of view. Meanwhile, the lens with the small field of view has a lower aberration level across its whole field of view. However, the field of view is small. In general, there is a trade off between the size of the field of view and the aberration level.

It is not essential for image quality property in which the high image quality region 21 differs from the low image quality region 22 to be aberration level. Alternatively, the image quality property is focus. For example the objective lens of the imager 15 may have a non-flat focal plan across the field of view. In an embodiment the objective lens is non-planar. In an embodiment the high image quality region 21 is a high focus region and the low image quality region 22 is a low focus region. The high focus region has better focus than the low focus region.

Alternatively, the image quality property is a degree of spatial coherence. For example a lower degree of spatial coherence may be better for reduced cross talk and/or speckle within the image data. In an embodiment the high image quality region 21 is a low spatial coherence region and the low image quality region 22 is a high spatial coherence region. The low spatial coherence region has lower spatial coherence than the high spatial coherence region.

Alternatively, the image quality property is transmission efficiency of the optical path. For example the transmission efficiency of the optical path may be higher near the optical axis. In an embodiment the high image quality region 21 is a high transmission efficiency region and the low image quality region 22 is a low transmission efficiency region. The high transmission efficiency region has higher transmission efficiency in the optical path than the low transmission efficiency region.

Alternatively, the image quality property is polarization retardance difference. For example, one polarization can have a different wave front phase error as a function of the position within the field of view. Typically the phase error between polarizations is lower near the center of the optical axis. In an embodiment the high image quality region 21 is a low polarization retardance difference region and the low image quality region 22 is a high polarization retardance difference region. The low polarization retardance difference region has a lower phase error between polarizations than the high polarization retardance difference region.

In an embodiment there is a plurality if image quality properties in which the high image quality region 21 differs from the low image quality region 22. For example, in an embodiment the high image quality region 21 differs from the low image quality region 22 in two or more selected from the group consisting of aberration level, focus, degree of spatial coherence, transmission efficiency of the optical path and polarization retardance difference. For brevity and clarity, embodiments are described primarily in the context of the image quality parameter being aberration level.

According to the present invention, the coarse alignment can be performed making use of the whole field of view. The coarse alignment does not require particularly low aberrations, such that an optical system with a relatively large field of view 20 may be used. In an embodiment the field of view has a diameter of at least 40 µm, optionally at least 50 µm , optionally at least 80 µm, optionally at least 100 µm, optionally at least 150 µm and optionally at least 200 µm. A larger field of view is desirable for facilitating measurement of alignment of the sample. It may not be necessary to accurately direct the imager 16 towards a small region of interest in order to be able to measure the alignment of the sample. An embodiment of the invention is expected to increase reliability of measuring alignment.

By performing the coarse alignment based on image data from anywhere within the field of view 20 and performing the fine alignment based on image data within the lower aberration region 21 a high quality alignment process can be performed with suffering from the trade-offs shown in Figure 5. In an embodiment the imager 16 is chosen to have a particularly low aberration level at some position within the field of view 20. The theoretical downside of having a particularly low aberration level at some position within the field of view 20 is that there may be particularly high aberration level elsewhere within the field of view 20. However, the present invention does not suffer from this theoretical downside because the coarse alignment can be performed even where a high aberration level is present. Meanwhile, the fine alignment can be performed where the aberration level is particularly low.

It is not essential that the distinctive feature 26 used to perform the coarse alignment is located in a low image quality region 22. It may be that by coincidence the distinctive feature is located in the high image quality region 21. The coarse alignment and the fine alignment may then be performed on substantially the same portion of the image data, i.e. image data corresponding to substantially the same region within the field of view 20.

By only requiring that the image 16 has low aberrations near the centre of the field of view 20 (or some other small portion within the field of view 20) it may not be necessary to use particularly expensive optics. An embodiment of the invention is expected to reduce the cost of measuring alignment. An embodiment of the invention is expected to reduce the cost of making an alignment sensor 15.

In an embodiment the sample comprises alignment marks specifically designed for the purpose of performing alignment measurements on the alignment marks. For example, the alignment marks may comprise one or more ratings to be measured by the alignment sensor 15. However, it is not essential to provide dedicated alignment marks in order for the alignment to be measured.

Figure 6 schematically depicts an alternative field of view 20 of the alignment sensor 15, with different features of the sample shown. In the arrangement shown in Figure 6, the sample comprises a periodic pattern 25. The periodic pattern 25 is a repetitive pattern across the sample. For example, Figure 6 schematically shows a two-dimensional grid that forms the periodic pattern 25. The two-dimensional grid comprises a plurality of elements arranged periodically within the two-dimensional grid. The elements 27 may corresponds to product features, for example. The periodic pattern 25 may be a periodic pattern 25 of product features 27. A product feature may be a feature that is intended to form part of an IC, for example, rather than being a feature used during manufacture of the IC. Alternatively at least one of the elements 27 may comprises a mark that is specifically (and only) designed for alignment purposes. The mark may have a regular structure. The two-dimensional grid may comprise a contact array. The periodic pattern 25 may have a substantially consistent pitch across the periodic pattern 25. For example, the pitch may be at least 100 nm, optionally at least 200 nm, optionally at least 500 nm and optionally at least 1 µm. In an embodiment the pitch is at most 10 µm, optionally at most 5 µm, optionally at most 2 µm and optionally at most 1 µm.

As shown in Figure 6, the sample may comprise a distinctive feature 26, which may be a break in the periodic pattern 25. The distinctive feature 26 may be an anomaly within the periodic pattern 25. The distinctive feature 26 may be a deviation from the regularity of the periodic pattern. For example, in the arrangement shown in Figure 6, the periodic pattern 25 comprises a plurality of elements 27. At the distinctive feature 26, the element 27 is absent (or missing). For example, there may be a single element 27 missing by design at the distinctive feature 26.

In an embodiment the imager 16 is configured to obtain the image data of the periodic pattern 25 of the region of interest. In an embodiment the controller 17 is configured to coarsely measure the alignment to an accuracy of at most one period of the periodic pattern 25. This means that the controller coarsely measures the alignment to an accuracy better than one period of the periodic pattern 25. For example, when the period is 1 µm, then the controller 17 may coarsely measure the alignment to an accuracy of 1 µm (or better, i.e. less than 1 µm).

In an embodiment the controller 17 is configured to finely measure the alignment to an accuracy of at least one order of magnitude smaller than one period of the periodic pattern 25. F or example, when the period is 1 µm, then the controller 17 may be configured to finely measure the alignment to an accuracy of within 100 nm, optionally within 50 nm, optionally within 20 nm, optionally within 10 nm, optionally within 5 nm and optionally within 2 nm.

The controller 17 may be configured to perform the coarse alignment and the fine alignment in either order, or simultaneously. The coarse alignment calculation of the fine alignment calculation are independent of each other in that neither requires the output of the other. Accordingly, they may be performed simultaneously or in series.

In an embodiment the controller 17 is configured to perform pattern recognition on the image data so as to coarsely measure the alignment based on a break in the periodic pattern. The break in the periodic pattern 25 may be the distinctive feature 26. For example, with the arrangement shown in Figure 6 the coarse position can be determined by pattern recognition, making use of the absent element that forms the distinctive feature 26. The coarse alignment measurement may be limited by the aberration level. In the arrangement shown in Figure 6, the distinctive feature 26 is in the low image quality region 22, outside of the high image quality region 21. The accuracy may be limited, for example to 300 nm.

In the region with low aberrations, i.e. the high image quality region 21, the fine alignment may be performed on the periodic pattern 25. The outputs of the coarse alignment and the fine alignment determinations provide the overall alignment measurement. If only the coarse alignment is performed, then the accuracy of the alignment measurement is significantly limited, for example by the aberrations in the low image quality region 22. If only the fine alignment is performed, then it may not be known whether the measured alignment is offset from the real alignment by a whole number of periods of the periodic pattern 25. By performing both the coarse alignment and the fine alignment, the overall alignment measurement may be performed accurately. Merely as an example to aid understanding, a fine alignment measurement may correspond to determining the phase within a period of a sinusoidal signal, and a coarse alignment measurement may correspond to determining the period of the sinusoidal signal.

As shown in Figure 6, only a single unique feature, i.e. the distinctive feature 26 is required to perform the measurement of the alignment.

In the example shown in Figure 6, the distinctive feature is that an element 27 of the periodic pattern 25 is missing or absent. However, it is not essential for the distinctive feature 26 to be an absent element. For example, in an alternative embodiment the distinctive features 26 comprises an element 27 of the periodic pattern 25 that has a size, shape (e.g. a two dimensional shape in plan view and/or a three dimensional shape) or position (e.g. spacing) different from the other elements 27 of the periodic pattern 25. In a further alternative embodiment, the distinctive feature 26 may be that an element 27 of the periodic pattern 25 has different material properties such that the signal recorded by the imager 16 is different for the distinctive feature 26 compared to for the other elements 27 of the periodic pattern 25.

Figure 7 schematically depicts an alternative field of view 20 so as to illustrate an alternative way of performing the alignment measurement. As shown in Figure 7, the sample comprises the periodic pattern 25 formed of elements 27 apart from one element being absent, thereby forming the distinctive feature 26. The distinctive feature 26 is located in the low image quality region 22 of the field of view 20 of the alignment sensor 15. The sample depicted in Figure 7 may be substantially the same as the sample shown in Figure 6, for example. The sample of Figure 7 may be measured using a lens that has such high aberrations over some of its field of view that it is only possible to coarsely measure the alignment to an accuracy of worse than one period of the periodic pattern 25. The coarse alignment accuracy may be worse in the example depicted in Figure 7. The coarse alignment accuracy may be insufficient for informing in which period the fine alignment is performed.

In an embodiment the controller 17 is configured to trace back the relative position between the distinctive feature 26 and where the fine alignment is performed. For example, when the fine alignment is performed substantially at the centre 23 of the field of view 20, then the controller 17 may be configured to trace back the distance between the centre 23 and the distinctive feature 26. For example, in an embodiment the controller 17 is configured to count the number of periods of the periodic pattern 22 between the distinctive feature 26 and the centre 23 (or other location where the fine alignment is performed). The number of periods may be counted in a plurality of dimensions, for example the two dimensions of the two-dimensional grid that forms the periodic pattern 25. The number of periods may be counted in the X direction and in the Y direction so as to determine the relative positions between the distinctive feature 26 and where the fine alignment is performed.

By tracing back the distance between the fine alignment and the absent element, the overall alignment measurement combining the coarse alignment and the fine alignment may be performed. An embodiment of the invention is expected to further optimise for lower aberrations in the high image quality region 21, while further increased aberrations away from the centre are not an issue. For example, in this arrangement the aberrations in the low image quality region 22 may be so high that the coarse alignment cannot be performed to within one period. However, it is possible to make use of the continuous image of the full field of view 20 and the known design as to trace back the relative positions between the distinctive feature 26 and the high image quality region 21 where the fine alignment is performed. An embodiment of the invention is expected to allow for very high aberrations within the field of view 20 of the alignment sensor 15. An embodiment of the invention is expected to increase the design freedom of the alignment sensor 15.

In an embodiment the controller 17 is configured to map the image data to the designed layout (e.g. to reference image data). For example, the controller 17 may adjust distortion so as to match the measured image data to the reference image data. In an embodiment the controller 17 is configured to determine coarse alignment in the high image quality region 21 based on the mapping and the reference image data,

As shown in Figure 6 and Figure 7, it is not essential for a purpose-built alignment mark to be used. Instead, the alignment mark may comprise a periodic pattern 25. The periodic pattern 25 may be of product features, for example features of an IC rather than specific alignment marks within a scribe lane that are not included in the IC that is manufactured. Alternatively, the periodic pattern 25 may be a regular structure that is only intended for alignment purposes. As shown in Figure 6 and Figure 7 the alignment mark may comprise a break in the periodic pattern 25 for facilitating coarse measurement of the alignment. When the periodic pattern 25 is formed of product features as the elements 27, then the product features may be provided in the die region of the substrate W, rather than within the scribe lane. Alternatively, the alignment mark may be provided in the scribe lane. In an embodiment each period of a the periodic pattern 25 comprises a set of product features. It is not essential for there to be any periodic pattern 25 within the full field of view 20. For example, the features in the low image quality region 22 may facilitate alignment even when there is insufficient variation within the high image quality region 21 to properly perform absolute alignment.

Figure 8 schematically depicts illumination within the field of view 20 of the alignment sensor 15. As shown in Figure 8, the high image quality region 21 is provided near the centre 23 of the field of view 20. The low image quality region 22 is located around the high image quality region 21. In general, the coarse alignment may be performed based on data corresponding to any position within the field of view 20. The fine alignment is performed based on image data within the high image quality region 21, for example near the centre 23 of the field of view 20.

As shown in Figure 8, in an embodiment the illuminator 18 is configured to illuminate the region of interest corresponding to the high image quality region 21 at a greater intensity than the distinctive feature 26. For example, a higher intensity of light may be illuminated onto the high image quality region 21 compared to onto the low image quality region 22. This is shown in Figure 8 which schematically depicts a high intensity region 31 closer to the centre 23 of the field of view 20. A low intensity region 32 is located closer to the edge of the field of view 20 of the alignment sensor 15.

In an embodiment the illuminator 18 is configured to illuminate the region of interest unevenly. By increasing the local intensity in the high image quality region 21, the signal to noise ratio may be increased for the fine alignment. An embodiment of the invention is expected to increase accuracy of the alignment measurement without unduly increasing illumination.

In an embodiment the illuminator 18 is configured to vary the light intensity of illumination across the region of interest according to a function (e.g. a mathematical function). In an embodiment the illuminator 18 is configured to illuminate the high image quality region 21 with at least 20%, optionally at least 40%, optionally at least 50%, optionally at least 60% and optionally at least 70% of the light used for illumination within the field of view 20. By increasing the percentage of the light used for the high image quality region 21, the accuracy of the fine alignment may be improved. It may not be necessary to use a high intensity of illumination within the low image quality region 22 because the coarse alignment may be performed even with a relatively low light intensity. An embodiment of the invention is expected to reduce the amount of light required to perform alignment measurements.

The alignment sensor 15 is described primarily in the context of a bonding tool. However, it is not essential for the alignment sensor 15 to be used only in a bonding tool. The alignment sensor 15 may be used as a level sensor or a topography measurement system, for example, in the context of the lithography.

Embodiments of the measurement system have been described primarily in the context of a bonding tool. However, it is not essential for the measurement system to be used only in a bonding tool. In an embodiment the alignment sensor 15 is part of a metrology apparatus. The metrology apparatus may be a tool configured to measure characteristics of structures on a substrate. For example, in an embodiment the metrology apparatus is configured to measure overlay. In an embodiment the metrology apparatus is configured to measure overlay based on features of the substrate (rather than based on an intensity imbalance). In an embodiment the metrology apparatus is configured to measure critical dimensions. In an embodiment the metrology apparatus is configured to align to certain positions on the substrate. The alignment sensor 15 of the metrology apparatus may be configured to facilitate alignment of the metrology apparatus to one or more target positions on the substrate.

In an embodiment the alignment sensor 15 is part of an inspection apparatus. In an embodiment the inspection apparatus is configured to inspect structures on a substrate. For example, the inspection apparatus may be configured to facilitate the finding of deviations from an expected (i.e. intended, designed) structure. In an embodiment the inspection apparatus is configured to align to certain positions on the substrate. The alignment sensor 15 of the inspection apparatus may be configured to facilitate alignment of the inspection apparatus to one or more target positions on the substrate. In an alternative embodiment the measurement system is used in a lithographic apparatus.

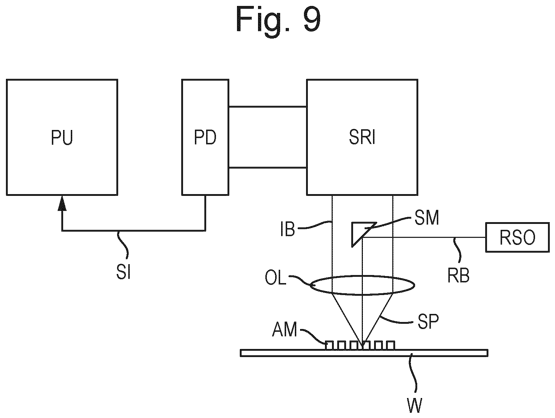

Figure 9 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor

(which is not explicitly depicted in Figure 9) may be used to accurately position the patterning device MA with respect to the path of the radiation beam B. Patterning device MA and substrate W may be aligned using mask alignment marks M₁, M₂ and substrate alignment marks P₁, P₂. Although the substrate alignment marks P₁, P₂ as illustrated occupy dedicated target portions, they may be located in spaces between target portions. Substrate alignment marks P₁, P₂ are known as scribe-lane alignment marks when these are located between the target portions C.

A topography measurement system, level sensor or height sensor, and which may be integrated in the lithographic apparatus, is arranged to measure a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate. Typically, the level or height sensor performs measurements at a fixed location (relative to its own optical system) and a relative movement between the substrate and the optical system of the level or height sensor results in height measurements at locations across the substrate.

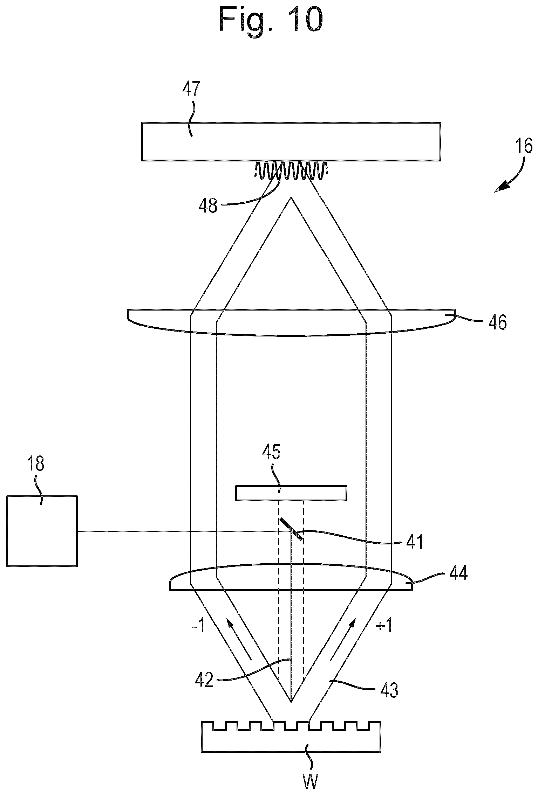

Figure 10 is a schematic block diagram of possible features of an imager 16 of an embodiment of the alignment sensor 15. The alignment sensor 15 is configured to perform an image-based alignment (rather than recording a modulated intensity signal during a movement, for example). As shown in Figure 10, in an embodiment the imager 16 comprises a microscope such as a dark field microscope. As shown in Figure 10, in an embodiment a beam splitter 41 is provided for directing illumination radiation from the illuminator 18 onto the substrate W. The illumination radiation may be directed along an illumination path 42.

As shown in Figure 10, in an embodiment the imager 16 comprises objective lens 44 configured to manipulate radiation from the substrate W. As shown in Figure 10, in an embodiment the imager 16 comprises a Oth order block 45 configured to block the Oth order of the radiation from the substrate W. The Oth order may be reflected from the substrate W. The Oth order block 45 may be referred to as a filter. The microscope may be a dark field microscope. Diffracted orders 43 of radiation may pass around the Oth order block. For example, Figure 10 shows the +1 diffracted order 43 and the -1 diffracted order 43 of radiation. Alternatively, the Oth order block 45 may be omitted. The imager 16 may comprise a bright field microscope. As shown in Figure 10, in an embodiment the imager 16 comprises a detector 47 configured to detect the radiation from the substrate W. In an embodiment the detector 47 is configured to detect an interference pattern 48 of the radiation from the substrate W. As shown in Figure 10, in an embodiment the imager 16 comprises optics 46 such as a lens configured to direct the radiation onto the detector 47.

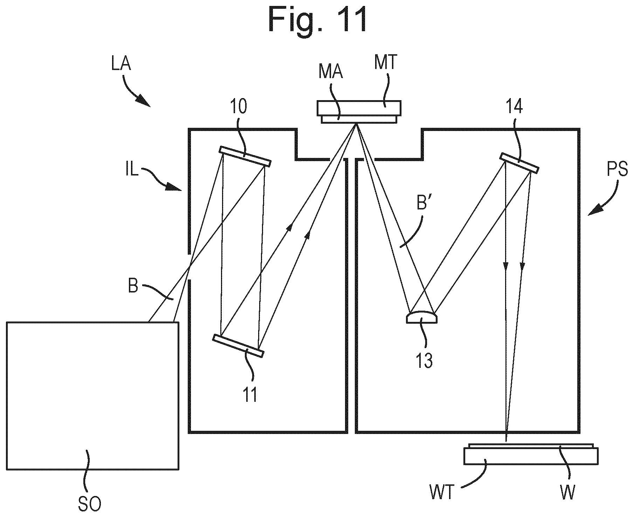

Figure 11 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 11, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Any embodiment of the topography measurement system may be integrated in a lithographic apparatus, such as the lithographic apparatus shown in Figure 9 or Figure 11. All embodiments of the alignment sensor 15 discussed in the context of a bonding tool also apply to a topography measurement system for a lithographic apparatus, such as the lithographic apparatus shown in Figure 9 or Figure 11.

Aspects of the invention are described in the following numbered clauses.
1. An alignment sensor configured to measure alignment of a sample, the alignment sensor comprising:
   an imager configured to obtain image data of a region of interest of the sample, the image data corresponding to a single image capturing process of the imager; and
   a controller configured to:
      coarsely measure the alignment of the sample within a field of view of the imager based on a distinctive portion of the image data, the distinctive portion corresponding to a distinctive feature of the sample within the region of interest; and
      finely measure the alignment based the image data corresponding to a high image quality region within the field of view at which the imager is configured to obtain image data with lower aberration than the distinctive portion.
2. The alignment sensor of clause 1, wherein the imager is configured such that the high image quality region is near a centre of the field of view.
3. The alignment sensor of clause 1 or 2, wherein the imager is configured to obtain the image data of a periodic pattern of the region of interest.
4. The alignment sensor of clause 3, wherein the controller is configured to coarsely measure the alignment to an accuracy of at most one period of the periodic pattern.
5. The alignment sensor of clause 3 or 4, wherein the controller is configured to finely measure the alignment to an accuracy of at least one order of magnitude smaller than one period of the periodic pattern.
6. The alignment sensor of clauses 3-5, wherein the controller is configured to perform pattern recognition on the image data so as to coarsely measure the alignment based on a break in the periodic pattern, the break in the periodic pattern being the distinctive feature.
7. The alignment sensor of any preceding clause, wherein the controller is configured to coarsely measure the alignment based on a relative position between the distinctive feature and the high image quality region within the field of view.
8. The alignment sensor of any preceding clause, comprising:
   an illuminator configured to illuminate the region of interest.
9. The alignment sensor of clause 8, wherein the illuminator is configured to illuminate the region of interest corresponding to the high image quality region at a greater intensity than the distinctive feature.
10. The alignment sensor of any preceding clause, wherein the field of view has a diameter of at least 50µm, optionally at least 100µm.
11. A bonding tool for bonding substrates together, the bonding tool comprising the alignment sensor of any preceding clause configured to measure alignment of a substrate to be bonded.
12. A lithographic apparatus for exposing a substrate with patterned radiation, the lithographic apparatus comprising the alignment sensor of any of clauses 1-10 configured to measure alignment of the substrate.
13. A metrology tool for measuring a characteristic of a structure on a substrate, the metrology tool comprising the alignment sensor of any of clauses 1-10.
14. An alignment mark to be imaged so as to measure alignment of a sample, the alignment mark comprising:
   a periodic pattern of product features; and
   a break in the periodic pattern for facilitating coarse measurement of the alignment.
15. A substrate comprising the alignment mark of clause 14, wherein the product features are in a die region of the substrate.
16. A method for calculating alignment of a sample, the method comprising:
   coarsely measuring the alignment of the sample within a field of view of an imager based on a distinctive portion of image data of a region of interest of the sample obtained in a single image capturing process of the imager, the distinctive portion corresponding to a distinctive feature of the sample within the region of interest; and
   finely measuring the alignment based on the image data corresponding to a high image quality region within the field of view at which the imager is configured to obtain image data with lower aberration than the distinctive portion.
17. A method for measuring alignment of a sample, the method comprising:
   obtaining the image data of the region of interest in a single image capturing process of the imager; and
   the method of clause 16.
18. A computer program comprising program instructions operable to perform the method of clause 16.
19. A non-transient computer program carrier storing the computer program of clause 18.
20. A metrology apparatus comprising the alignment sensor of any of clauses 1-10.
21. An inspection apparatus comprising the alignment sensor of any of clauses 1-10.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An alignment sensor configured to measure alignment of a sample, the alignment sensor comprising:
an imager configured to obtain image data of a region of interest of the sample, the image data corresponding to a single image capturing process of the imager; and
a controller configured to:
coarsely measure the alignment of the sample within a field of view of the imager based on a distinctive portion of the image data, the distinctive portion corresponding to a distinctive feature of the sample within the region of interest; and
finely measure the alignment based the image data corresponding to a high image quality region within the field of view at which the imager is configured to obtain image data with lower aberration than the distinctive portion.

2. The alignment sensor of claim 1, wherein the imager is configured such that the high image quality region is near a centre of the field of view.

3. The alignment sensor of claim 1 or 2, wherein the imager is configured to obtain the image data of a periodic pattern of the region of interest.

4. The alignment sensor of claim 3, wherein the controller is configured to coarsely measure the alignment to an accuracy of at most one period of the periodic pattern.

5. The alignment sensor of claim 3 or 4, wherein the controller is configured to finely measure the alignment to an accuracy of at least one order of magnitude smaller than one period of the periodic pattern.

6. The alignment sensor of claims 3-5, wherein the controller is configured to perform pattern recognition on the image data so as to coarsely measure the alignment based on a break in the periodic pattern, the break in the periodic pattern being the distinctive feature.

7. The alignment sensor of any preceding claim, wherein the controller is configured to coarsely measure the alignment based on a relative position between the distinctive feature and the high image quality region within the field of view.

8. The alignment sensor of any preceding claim, comprising:
an illuminator configured to illuminate the region of interest.

9. The alignment sensor of claim 8, wherein the illuminator is configured to illuminate the region of interest corresponding to the high image quality region at a greater intensity than the distinctive feature.

10. The alignment sensor of any preceding claim, wherein the field of view has a diameter of at least 50µm, optionally at least 100µm.

11. A bonding tool for bonding substrates together, the bonding tool comprising the alignment sensor of any preceding claim configured to measure alignment of a substrate to be bonded.

12. A lithographic apparatus for exposing a substrate with patterned radiation, the lithographic apparatus comprising the alignment sensor of any of claims 1-10 configured to measure alignment of the substrate.

13. A metrology tool for measuring a characteristic of a structure on a substrate, the metrology tool comprising the alignment sensor of any of claims 1-10.

14. A method for calculating alignment of a sample, the method comprising:
coarsely measuring the alignment of the sample within a field of view of an imager based on a distinctive portion of image data of a region of interest of the sample obtained in a single image capturing process of the imager, the distinctive portion corresponding to a distinctive feature of the sample within the region of interest; and
finely measuring the alignment based on the image data corresponding to a high image quality region within the field of view at which the imager is configured to obtain image data with lower aberration than the distinctive portion.

15. A method for measuring alignment of a sample, the method comprising:
obtaining the image data of the region of interest in a single image capturing process of the imager; and
the method of claim 14.
